(19) Europäisches Patentamt — European Patent Office — Office européen des brevets

(11) **EP 2 800 271 B1**

(12) **FASCICULE DE BREVET EUROPEEN**

(45) Date de publication et mention de la délivrance du brevet:
**29.06.2016 Bulletin 2016/26**

(51) Int Cl.:
*H03F 3/189* *(2006.01)*   *H03F 3/20* *(2006.01)*
*H03F 3/68* *(2006.01)*   *H03F 3/60* *(2006.01)*
*H04B 1/04* *(2006.01)*   *H03F 3/21* *(2006.01)*

(21) Numéro de dépôt: **14166625.5**

(22) Date de dépôt: **30.04.2014**

(54) **Procédé de calibrage d'un amplificateur multiport, amplificateur multiport permettant la mise en ouvre d'un tel procédé et satellite comprenant un tel amplificateur**

Kalibrierungsverfahren für einen Multiport-Verstärker, Multiport-Verstärker geeignet für die Anwendung dieser Verfahren und Satelliten mit einen solchen Verstärker

Calibration method for a multiport amplifier, multiport amplifier suitable for applying this method and satelite comprising such an amplifier

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **03.05.2013 FR 1301031**

(43) Date de publication de la demande:
**05.11.2014 Bulletin 2014/45**

(73) Titulaire: **Thales**
**92200 Neuilly Sur Seine (FR)**

(72) Inventeur: **Moreau, Pierre-Henry**
**31100 TOULOUSE (FR)**

(74) Mandataire: **Priori, Enrico et al**
**Marks & Clerk France**
**Conseils en Propriété Industrielle**
**Immeuble «Visium»**
**22, avenue Aristide Briand**
**94117 Arcueil Cedex (FR)**

(56) Documents cités:
**US-A- 6 006 111        US-A1- 2012 280 748**
**US-A1- 2012 319 772**

• **ZHIWEN ZHU ET AL: "Ka-Band Multi-port Power Amplifier Calibration Experiment and Results", ADVANCES IN SATELLITE AND SPACE COMMUNICATIONS (SPACOMM), 2010 SECOND INTERNATIONAL CONFERENCE ON, IEEE, PISCATAWAY, NJ, USA, 13 juin 2010 (2010-06-13), pages 11-14, XP031703522, ISBN: 978-1-4244-7275-8**

## Description

L'invention porte sur un procédé de calibrage d'un amplificateur multiport, permettant de maximiser l'isolement entre ses sorties. L'invention porte également sur un amplificateur multiport comprenant des moyens de mise en oeuvre d'un tel procédé, ainsi que sur un satellite, notamment pour télécommunications, dont la charge utile comprend un tel amplificateur.

L'invention s'applique principalement au domaine des télécommunications, et particulièrement des télécommunications spatiales.

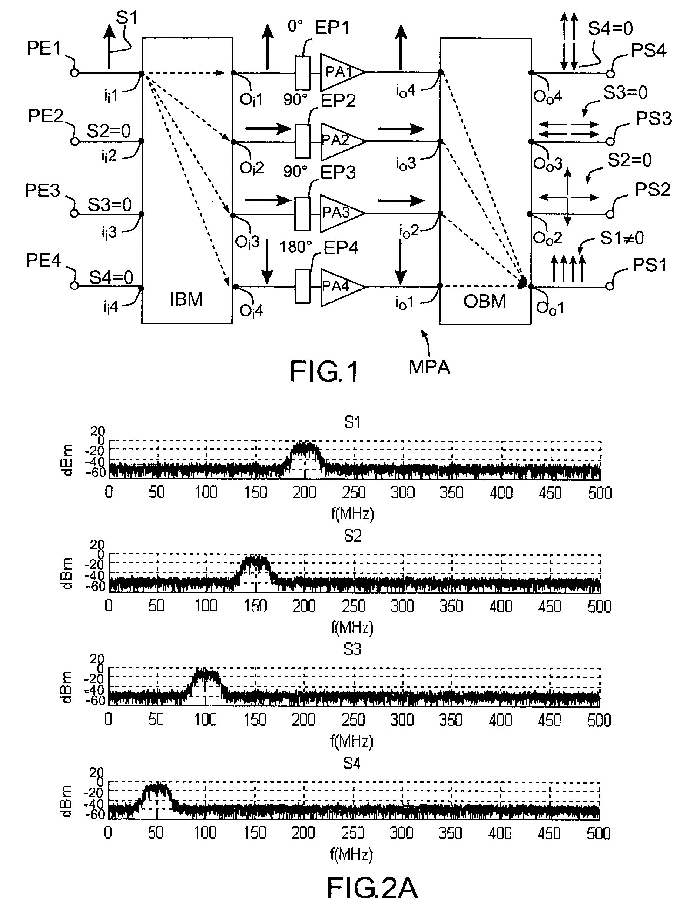

Les amplificateurs multiports (MPA de l'anglais « MultiPort Amplifiers ») sont des systèmes utilisés principalement dans les charges utiles des satellites de télécommunications pour amplifier une pluralité de signaux à radiofréquences ou à microondes, par exemple pour réaliser des transpondeurs à large bande. Le principe de fonctionnement d'un MPA consiste à utiliser plusieurs amplificateurs pour amplifier concurremment tous les signaux. Tous les amplificateurs, ou au moins plusieurs d'entre eux, contribuent à l'amplification de tous les signaux ; cela permet une allocation flexible de la puissance et de la bande, tout en assurant une utilisation optimale des amplificateurs. Ce principe de fonctionnement, connu en soi, est illustré par la figure 1 qui représente schématiquement un amplificateur multiport présentant quatre ports d'entrée PE1 - PE4, par lesquels entrent quatre signaux à radiofréquences s1 - s4, et quatre ports de sortie PS1 - PS4, par lesquels sortent les signaux amplifiés S1 - S4. Les ports d'entrée sont reliés aux entrées $i_i1$ - $i_i4$ d'une matrice de distribution, ou matrice d'entrée IBM, qui présente un même nombre de sorties $o_i1$ - $o_i4$. Cette matrice est configurée de telle manière que le signal si (par exemple s1, représenté par un vecteur d'orientation verticale) présent à une entrée (dans ce cas, $i_i1$) soit reparti sur toutes ses sorties avec un déphasage différent (indiqué par le changement d'orientation des vecteurs). Ainsi, par exemple, le signal s1 se retrouve sans déphasage à la sortie $o_i1$, avec un déphasage de 90° aux sorties q2 et $o_i3$ et avec un déphasage de 180° à la sortie q4. Il en va de même, avec des déphasages différents, pour les signaux s2 - s4 (non représentés). Ce mode de fonctionnement correspond à une matrice « de Butler », connue en soi.

Les signaux issus des sorties $o_{i1}$ - $o_i4$, qui sont donc des combinaisons linéaires des signaux d'entrée s1 - s4, sont amplifiés par des amplificateurs de puissance identiques PA1 - PA4, qui peuvent être, par exemple, du type à tube à onde progressive (TWTA, de l'anglais « Travelling Wave Tube Amplifier ») ou à semi-conducteur. Les signaux amplifiés sont appliqués aux entrées $i_o1$ - $i_o4$ d'une matrice de combinaison, ou de sortie OBM, qui réalise une opération analogue à celle de la matrice de distribution ; dans le cas de la figure 1, OBM est également une matrice de Butler.

On peut voir sur la figure 1 que, si les déphasages introduits par les deux matrices sont choisis de façon opportune, les vecteurs représentatifs du signal s1 amplifié s'annulent sur les sorties $o_o2$ - $o_o4$, et se combinent sur la seule sortie $o_o1$. De même, les vecteurs représentatifs du signal s2 amplifié s'annulent sur les sorties $o_o1$, $o_o3$ et $o_o4$, et se combinent de manière constructive sur la seule sortie $o_o2$, et ainsi de suite. Ainsi, le signal amplifié Si, issu du port de sortie Pi, correspond au signal d'entrée si amplifié, sans aucune contribution des autres signaux d'entrée sj avec j≠ (i,j= 1 - 4).

Ce fonctionnement présuppose des matrices d'entrée et de sortie idéales et des amplificateurs de puissance aux propriétés rigoureusement identiques. En réalité, ce n'est pas le cas : les déphasages introduits par les matrices peuvent être différents de ceux nominaux, la puissance des signaux en entrée peut être inégalement repartie entre les sorties, les amplificateurs peuvent présenter des gains et des phases différents, etc. En outre, les propriétés de différents éléments peuvent dériver dans le temps. A cause de ces écarts par rapport à une situation idéale, l'isolement entre les différentes sorties de l'amplificateur multiport n'est pas parfait ; cela signifie que, sur chaque port de sortie PSi on trouvera des termes d'interférence correspondant aux signaux d'entrée sj avec j≠i.

La figure 2A montre les spectres des signaux de sortie dans le cas d'un MPA parfaitement équilibré (les modèles des matrices de Butler sont parfaits) ; les densités spectrales de puissance sont exprimées en dBm et les fréquences (f) en GHz. On peut remarquer que chaque signal de sortie Si - qui est une version amplifiée d'un signal d'entrée si correspondant - présente une bande d'environ 50 MHz de largeur et une fréquence centrale (fréquence de la porteuse) différente, de telle sorte que les bandes des différents signaux ne se recouvrent pas : on parle alors de « plan de fréquences disjoint ». On peut voir que l'isolement est pratiquement parfait (niveau d'interférence inférieur à -43 dB), car les interférences entre signaux sont invisibles à l'oeil nu. L'isolement est défini comme la différence (en décibels) des puissances intégrées dans la bande du signal de référence (dans le cas présent, 50 MHz).

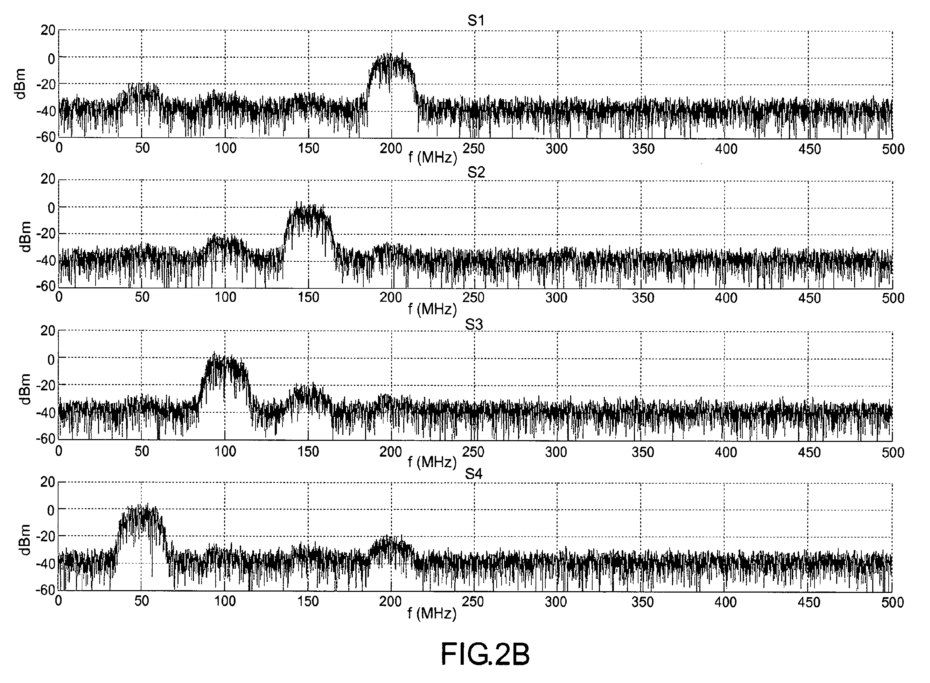

La figure 2B montre les spectres obtenus en introduisant des déséquilibres aléatoires définis par des distributions gaussiennes des erreurs d'amplitude et de phase avec ($J_A$ (écart type de l'erreur d'amplitude)=0,8 dB et $\sigma_\phi$ (écart type de l'erreur de phase)=3° ; les modèles des matrices de Butler sont « réels » (issus de mesures). Les interférences entre signaux sont clairement visibles, et un calcul permet de déterminer que le niveau d'interférence est de l'ordre de -22 dB.

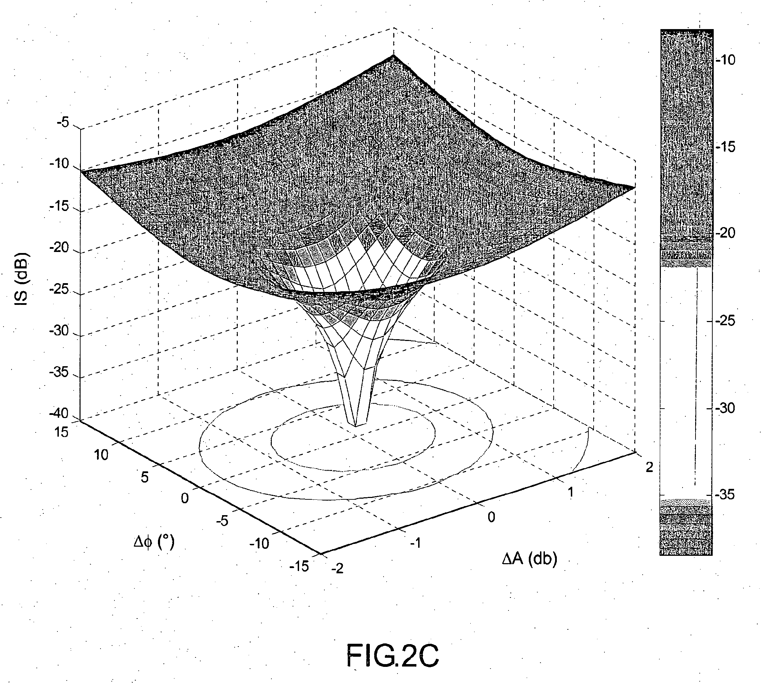

Le graphique de la figure 2C montre comment des déséquilibres en phase ($\Delta\Phi$, en degrés « ° ») et en amplitude ($\Delta A$, en dB) affectent l'isolement IS (en dB) entre deux sorties d'un amplificateur multiport.

Pour remédier à ces déséquilibres, l'amplificateur de la figure 1 comprend des éléments de pondération EP1 - EP4, constitués chacun par un atténuateur (plus rarement un préamplificateur) et un déphaseur ajustables reliés en cascade, associés à des amplificateurs respectifs et généralement connectés en amont de ces derniers. Comme seuls importent les atténuations et déphasages relatifs entre les sorties, un des éléments de pondération peut optionnellement être omis.

En ajustant de manière opportune les poids complexes introduits par ces éléments de pondération il est possible de restaurer un isolement presque idéal - et en tout cas supérieur à 20 dB ou plus - entre les sorties. L'opération de calibrage consistant à ajuster ces poids complexes peut être réalisée de façon manuelle par un technicien ou, de préférence, de manière automatique.

Le document WO 2008/135753 décrit un procédé automatique de calibrage d'un amplificateur multiport visant à maximiser l'isolement entre les sorties, utilisant un signal de mesure ou de test injecté dans une entrée. Le principal inconvénient de ce procédé est que le signal injecté est amplifié et, dans un système de télécommunications, détériore le rapport signal sur interférence C/I.

L'article de Mario Caron et Xinping Huang « Estimation and compensation of amplifier gain and phase mismatches in a multiple port amplifier subsystem », ESA Workshop on Advanced Flexible Telecom Payloads 18- 20 novembre 2008, Noordwijk (Pays-Bas), divulgue un procédé automatique de calibrage d'un amplificateur multiport ne nécessitant pas l'injection d'un signal de mesure. Ce procédé se base sur l'étude des fonctions de densité de probabilité des signaux de sortie pour identifier, et minimiser, les interférences entre sorties. Cela n'est possible que si le type de modulation utilisé est connu avec précision, ce qui limite la flexibilité de la solution.

Le document US 2012/0319772 divulgue un procédé de calibrage d'un amplificateur multiport visant à minimiser l'intercorrélation entre les signaux de sortie. La mise en oeuvre d'un tel procédé parait complexe et sensible aux fluctuations temporelles des signaux.

L'invention vise à procurer un procédé automatique de calibrage d'un amplificateur multiport visant à maximiser l'isolement entre les sorties ne présentant pas, ou présentant sous une forme atténuée, les inconvénients de l'art antérieur. Plus particulièrement, l'invention vise à éviter l'injection d'un signal de mesure ou de calibrage que l'on retrouverait superposé aux signaux de trafic, et à ne pas introduire de contrainte relative au type de modulation employé.

Un objet de l'invention permettant d'atteindre ce but est un procédé de calibrage d'un amplificateur multiport comportant une pluralité de ports d'entrée, une pluralité d'amplificateurs de puissance reliés auxdits ports d'entrées par l'intermédiaire d'une matrice de distribution de signaux et une pluralité de ports de sortie reliés auxdits amplificateurs de puissance par l'intermédiaire d'une matrice de recombinaison de signaux, lesdites matrices de distribution et de recombinaison de signaux étant adaptées pour repartir un signal présent à un dit port d'entrée entre une pluralité desdits amplificateurs de puissance et pour recombiner ledit signal, amplifié, au niveau d'un dit port de sortie, un élément de pondération des signaux étant associé à chaque dit amplificateur de puissance ; le procédé étant caractérisé en ce qu'il comporte les étapes consistant à :

    a) déterminer une intercorrélation moyenne normalisée entre un signal de sortie présent à un dit port de sortie, pris comme référence, et les signaux présents aux autres dits ports de sortie ; et
    b) ajuster itérativement des poids desdits éléments de pondération de façon à minimiser ladite intercorrélation moyenne normalisée où à la rendre inférieure à un seuil prédéterminé.

Selon des modes de réalisation particuliers d'un tel procédé :

- Ladite intercorrélation moyenne normalisée peut être normalisée par rapport à une auto-corrélation moyenne du signal présent audit port de sortie pris comme référence.
- Le port de sortie pris comme référence peut être celui qui présente le signal ayant le niveau de puissance le plus élevé.
- Lesdits poids peuvent être des poids complexes, comportant chacun un module et une phase, ladite étape b) comprenant les sous-étapes consistant à :

    b1) ajuster itérativement les phases desdits poids ; et
    b2) ajuster itérativement les modules desdits poids.

Plus particulièrement, lesdites sous-étapes b1) et b2) peuvent être mises en oeuvre successivement, dans un ordre arbitraire, ladite sous-étape b1) peut comporter l'ajustement successif des phases des poids des éléments de pondération associés aux différents amplificateurs de puissance, et ladite sous-étape b2) peut comporter l'ajustement successif des modules des poids des éléments de pondération associés aux différents amplificateurs de puissance.

- Ladite étape b) peut comporter les opérations suivantes :

    i. déterminer ladite intercorrélation moyenne normalisée ;
    ii. appliquer un incrément prédéfini au module et/ou à la phase d'un dit poids à ajuster ;
    iii. déterminer à nouveau ladite intercorrélation moyenne normalisée et, si sa valeur a augmenté, changer le signe dudit incrément ; et
    iv. appliquer ledit incrément prédéfini à la phase et/ou au module dudit poids à ajuster, avec le signe déterminé lors de l'opération iii ;
    v. déterminer à nouveau ladite intercorrélation moyenne normalisée et, si sa valeur a diminué tout en restant supérieure à un seuil prédéfini, répéter les opérations iv. et v.

- Lesdites corrélations moyennes normalisées peuvent être déterminées à l'intérieur d'une bande de fréquence sensiblement coïncidente avec celle du signal présent sur ledit port de référence.
- Les signaux présents sur lesdits ports de sortie peuvent présenter un plan de fréquence disjoint.
- De préférence, aucun signal de mesure n'est injecté dans ledit amplificateur afin de réaliser le calibrage.

Un autre objet de l'invention est un amplificateur multiport comportant une pluralité de ports d'entrée, une pluralité d'amplificateurs de puissance reliés auxdits ports d'entrées par l'intermédiaire d'une matrice de distribution de signaux et une pluralité de ports de sortie reliés auxdits amplificateurs de puissance par l'intermédiaire d'une matrice de recombinaison de signaux, lesdites matrices de distribution et de recombinaison de signaux étant adaptées pour repartir un signal présent à un dit port d'entrée entre une pluralité desdits amplificateurs de puissance et pour recombiner ledit signal, amplifié, au niveau d'un dit port de sortie, un élément de pondération des signaux étant associé à chaque dit amplificateur de puissance ; caractérisé en ce qu'il comprend également un module de calibrage configuré ou programmé pour mettre en oeuvre un procédé de calibrage tel qu'exposé ci-dessus.

Selon des modes de réalisation particuliers d'un tel amplificateur multiport :

- Ledit module de calibrage peut comprendre : un premier et un deuxième sélecteur pour sélectionner un premier et un deuxième port de sortie ; une première et une deuxième chaîne d'acquisition des signaux présents sur lesdits premier et deuxième ports de sortie, pour sélectionner, convertir à une fréquence intermédiaire, filtrer et numériser lesdits signaux ; et un processeur programmé ou configuré pour : piloter lesdits premier et deuxième sélecteurs et lesdites première et deuxième chaînes d'acquisition ; acquérir les signaux numérisés issues desdites chaines d'acquisition ; à partir des signaux numérisés acquis, calculer une intercorrélation moyenne normalisée entre un signal de sortie acquis depuis un port de sortie, pris comme référence, et les signaux acquis depuis les autres ports de sortie ; ajuster itérativement les poids desdits éléments de pondération pour minimiser ladite intercorrélation moyenne normalisée ou la rendre inférieure à un seuil prédéterminé.
- Ledit processeur peut être déporté en totalité ou en partie.
- Chaque dit élément de pondération peut comprendre un atténuateur variable et un déphaseur variable connectés en cascade.

- L'amplificateur peut, de préférence, opérer dans au moins une bande choisie parmi la bande Ku, la bande K et la bande Ka. En fait, l'invention est d'autant plus utile que la fréquence des porteuses est élevée, ainsi que lorsque les amplificateurs de puissance sont des tubes à onde progressive. Ainsi, la bande Ka constitue un domaine privilégié d'application de l'invention.

Encore un autre objet de l'invention est un satellite pour télécommunications dont la charge utile comprend un amplificateur multiport tel qu'exposé ci-dessus.
D'autres caractéristiques, détails et avantages de l'invention ressortiront à la lecture de la description faite en référence aux dessins annexés donnés à titre d'exemple et qui représentent, respectivement :

- la figure 3, un schéma de principe d'un amplificateur multiport selon un mode de réalisation de l'invention ;
- la figure 4, un organigramme de la procédure d'ajustement des poids complexes des éléments de pondération permettant de maximiser l'isolement entre les sorties de l'amplificateur de la figure 3 ;
- les figures 5A et 5B des spectres des sorties de l'amplificateur de la figure 3 illustrant le résultat technique de l'invention ; et
- la figure 6, schématiquement, l'intégration d'un amplificateur multiport selon un mode de réalisation de l'invention dans un satellite de télécommunications.

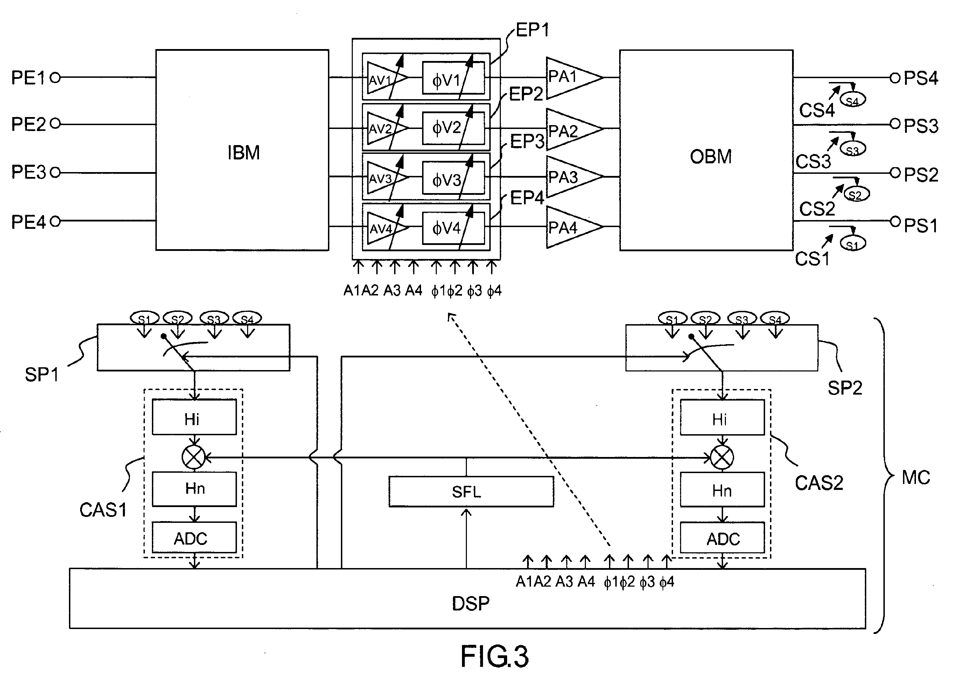

Comme illustré sur la figure 3, un MPA selon un mode de réalisation de l'invention se différencie de celui de la figure 1 en ce qu'il comprend un module de calibrage MC qui reçoit en entrée une fraction des signaux S1 - S4 présents sur les ports de sortie - prélevés par des coupleurs de signaux CS1 à CS4 - et génère des signaux de pilotage des éléments de pondération EP1 - EP4. Plus précisément, dans le mode de réalisation considéré ici, chaque élément de pondération comprend un atténuateur variable AVi qui reçoit un signal de pilotage Ai et un déphaseur variable ΦVi qui reçoit un signal de pilotage Φi (i=1- 4).
Deux sélecteurs SP1, SP2 sélectionnent indépendamment un port de sortie chacun (plus précisément : sélectionnent chacun un signal prélevé par un coupleur de signal sur un port de sortie). Les signaux sélectionnés sont traités par des chaines d'acquisition respectives, CAS1, CAS2 qui comprennent, classiquement, un filtre image Hi, un mélangeur pour convertir les signaux à une fréquence intermédiaire, un filtre de Nyquist Hn et un convertisseur analogique/numérique ADC. Les signaux numériques ainsi obtenus sont traités par un processeur DSP pour générer les signaux de pilotage A1 - A4, Φ1 - Φ4. Le processeur DSP pilote également les sélecteurs SP1, SP2 et le synthétiseur de fréquence locale SFL, utilisé pour la conversion de fréquence.
Le processeur DSP est de préférence un processeur numérique - et notamment un processeur pour traitement numérique de signaux - programmé de manière opportune, mais d'autres possibilités (par exemple, la réalisation d'un circuit numérique dédié) sont envisageables.

Selon un mode de réalisation particulier de l'invention, le calibrage de l'amplificateur multiport est réalisé de la manière suivante.

Premièrement, le processeur DSP identifie le port de sortie correspondant au signal présentant la puissance la plus élevée. Cette sélection est effectuée en balayant les sorties au moyen de l'un des sélecteurs et en intégrant la puissance des signaux acquis dans la bande de Nyquist (ou dans une bande plus étroite, sélectionnée par un filtre de préférence numérique). Cela nécessite de connaitre le plan de fréquence afin de régler le synthétiseur de fréquence locale SFL sur la fréquence centrale de chaque sortie. Le port de sortie ainsi identifié - dans la suite, PS1 - est pris comme référence.

Ensuite le premier sélecteur SP1 est piloté pour sélectionner, sur une fenêtre temporelle prédéfinie ledit port de référence, tandis que le deuxième sélecteur SP2 est piloté pour sélectionner, sur une même fenêtre temporelle, un autre port de sortie. Cette opération est répétée pour tous les ports de sortie. On obtient ainsi trois paires de signaux acquis est numérisés ($S1_{(2)}$, S2) ; ($S1_{(3)}$, S3), ($S1_{(4)}$, S4), où $S1_{(i)}$ identifie le signal S1 acquis simultanément à Si avec i=2 - 4. Cela permet le calcul, par le processeur DSP, des corrélations croisées, ou intercorrélations, entre les signaux $S1_{(i)}$ et Si avec i=2 - 4, dont les maxima sont indiqués par $R_{1i}$: $R_{12}$, $R_{13}$ et $R_{14}$. On calcule également les puissances des signaux $S1_{(i)}$, qu'on indique par $P_{1(Ta1i)}$ ; ainsi $\boldsymbol{P}_{1(Ta_{12})}$ est la puissance du signal $S1_{(2)}$ prélevé par le port PS1 pendant l'acquisition synchrone des signaux S1 et S2 ; $\boldsymbol{P}_{1(Ta_{13})}$ est la puissance du signal $S1_{(2)}$ prélevé par le port PS1 pendant l'acquisition synchrone des signaux S1 et S3 et $\boldsymbol{P}_{1(Ta_{14})}$ est la puissance du signal $S1_{(2)}$ prélevé par le port PS1 pendant l'acquisition synchrone des signaux S1 et S4.

Cela permet le calcul d'une intercorrélation moyenne normalisée :

$$ C_{(0)} = \frac{R_{12}}{P_{1(Ta_{12})}} + \frac{R_{13}}{P_{1(Ta_{13})}} + \frac{R_{14}}{P_{1(Ta_{14})}} $$

La généralisation au cas de N port, avec N entier supérieur à 1 - et généralement pair - est immédiate.

L'indice (0) signifie qu'il s'agit de l'intercorrélation moyenne normalisée déterminée avant la première itération du processus d'ajustement des coefficients de pondération, comme cela sera expliqué plus loin.

De préférence, les intercorrélations sont calculées en prenant en considération seulement la bande du signal présent sur le port de référence. Ainsi, le processeur DSP pilote le synthétiseur de fréquence locale SFL de manière à sélectionner la porteuse du signal s1 ; le filtrage de ce signal est assuré par l'échantillonnage ; toutefois, si sa bande est plus étroite que la bande de Nyquist, un filtrage additionnel - de préférence numérique, par le processeur DSP - peut être prévu.

Un principe à la base de l'invention consiste à ajuster itérativement les poids complexes des éléments de pondération EP1 - EP4 de manière à minimiser l'intercorrélation moyenne normalisée, ou tout au moins à assurer qu'elle est inférieure à un seuil prédéfini. En effet, plus l'intercorrélation moyenne normalisée est élevée, moins les sorties de l'amplificateur multiport sont isolées entre elles.

Plusieurs algorithmes d'optimisation peuvent être utilisés pour réaliser cet ajustement itératif.

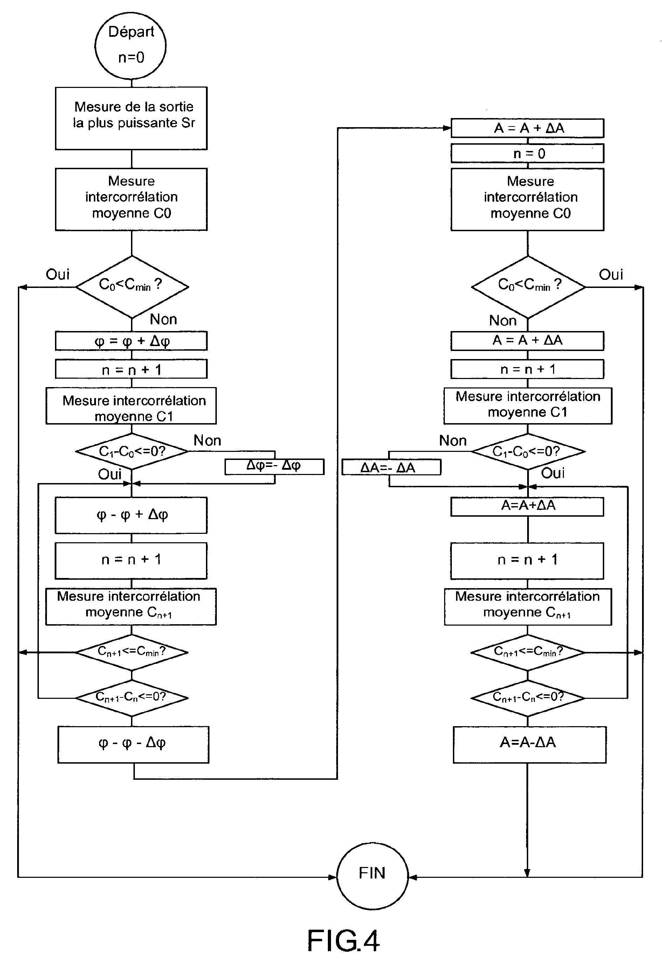

L'un d'entre eux sera décrit ci-après à l'aide de la figure 4. Le principe de cet algorithme consiste à incrémenter la phase du poids d'un élément de pondération d'un pas prédéfini (positif ou négatif), déterminer si cela conduit à une diminution de l'intercorrélation moyenne normalisée et : dans l'affirmative, appliquer à nouveau l'incrément ; dans le cas contraire, changer son signe avant de l'appliquer à nouveau. Après avoir ajusté de cette façon les phases de tous les éléments de pondération, on procède de la même manière pour les amplitudes. Ensuite, on peut itérer le processus. En variante on peut ajuster d'abord les amplitudes, ou ajuster l'amplitude et la phase d'un élément avant de passer au suivant.

Comme le montre la figure 4, les premières opérations de l'algorithme sont : la détermination de la sortie la plus puissante Sr, la mesure de sa puissance et la mesure de l'intercorrélation (normalisée) moyenne $C_{(0)}$ - ou plus proprement son calcul à partir des signaux acquis. Ensuite on vérifie si cette intercorrélation normalisée moyenne est supérieure à un seuil prédéterminé $C_{min}$, car dans le cas contraire on peut considérer que l'isolement est déjà suffisant et qu'aucun calibrage n'est nécessaire.

Ensuite on incrémente la phase (p du poids complexe d'un premier élément de pondération d'un pas $\Delta\phi$ de valeur prédéfinie, et on recalcule l'intercorrélation (normalisée) moyenne, $C_{(1)}$. On détermine alors si l'intercorrélation nouvellement calculée $C_{(1)}$ est plus grande ou plus petite que $C_{(0)}$ ; si elle est plus grande, cela signifie que l'incrément de phase a augmenté les déséquilibres au lieu de les réduire ; on change donc le signe du pas de l'incrément : $\Delta\phi \rightarrow -\Delta\phi$ ; autrement, on laisse ce pas inchangé. Ensuite, on procède avec des incréments successifs - toujours d'un même pas, dont le signe a été déterminé une fois pour toutes après la première itération qu'on vient de décrire - jusqu'à ce que l'une des conditions suivantes ne soit vérifiée :

- soit l'intercorrélation moyenne descend au-dessous du seuil $C_{min}$, auquel cas on considère que l'isolement est suffisant et le processus s'arrête ;
- soit l'intercorrélation moyenne commence à aug-

menter ($C_{(n+1)} > C_{(n)}$), ce qui signifie qu'on a dépassé le point de réglage optimal ; dans ce cas, on soustrait $\Delta\phi$ à la phase du poids complexe pour revenir au meilleur réglage identifié, et on passe à l'ajustement de l'élément de pondération successif (dans un souci de simplicité, l'organigramme de la figure 1 est limité au cas d'un seul élément de pondération).

Lorsque toutes les phases ont été ajustées, et si l'intercorrélation moyenne n'est pas inférieure au seuil $C_{min}$, on passe à l'ajustement des amplitudes suivant la même méthode (partie droite de l'organigramme).

Puis, si l'isolement n'est toujours pas satisfaisant, on itère à nouveau (non représenté).

Bien entendu, il est possible d'imposer un nombre maximal d'itérations à ne pas dépasser, que ce soit pour l'ajustement de la phase et/ou de l'amplitude de chaque élément ou pour la procédure dans son ensemble.

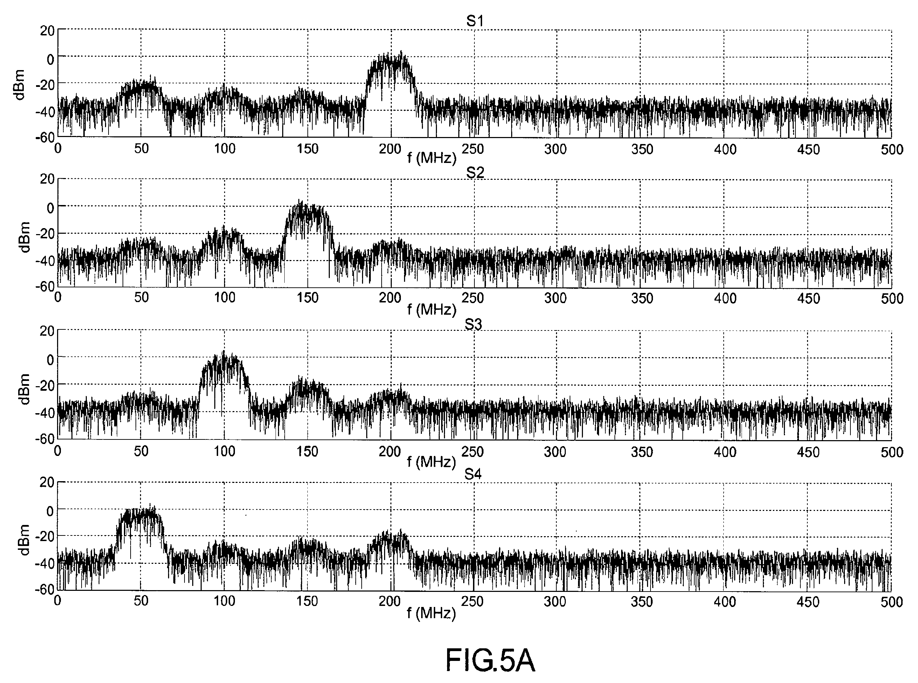

Les figures 5A - 5C permettent d'illustrer le résultat technique de l'invention. Elles montrent les spectres des signaux de sortie de l'amplificateur multiport de la figure 3 obtenus par simulations numériques dans les conditions suivantes :

- Les déséquilibres des amplitudes et des phases suivent des distributions gaussiens avec $\sigma A$ = 0,8dB et $\sigma\phi$ = 3° ;
- Dynamique en puissance des porteuses = 3 dB ;
- Acquisition des signaux sur $2^{13}$ points ;
- Limitation de la bande à 50MHz (échantillonnage à 100MHz) ;
- Une porteuse modulée en QPSK avec largeur de bande de 20MHz sur chaque entrée ;
- Porteuses equiréparties entre 50MHz et 200 MHz ;
- Modèles des Matrice de Butler issus de mesures sur des dispositifs réels.
- Pas de modélisation des effets AM/AM (variations du gain avec le point de fonctionnement en puissance) et AM/PM (variation de la phase de la fonction de transfert avec le point de fonctionnement en puissance) des amplificateurs de puissance.

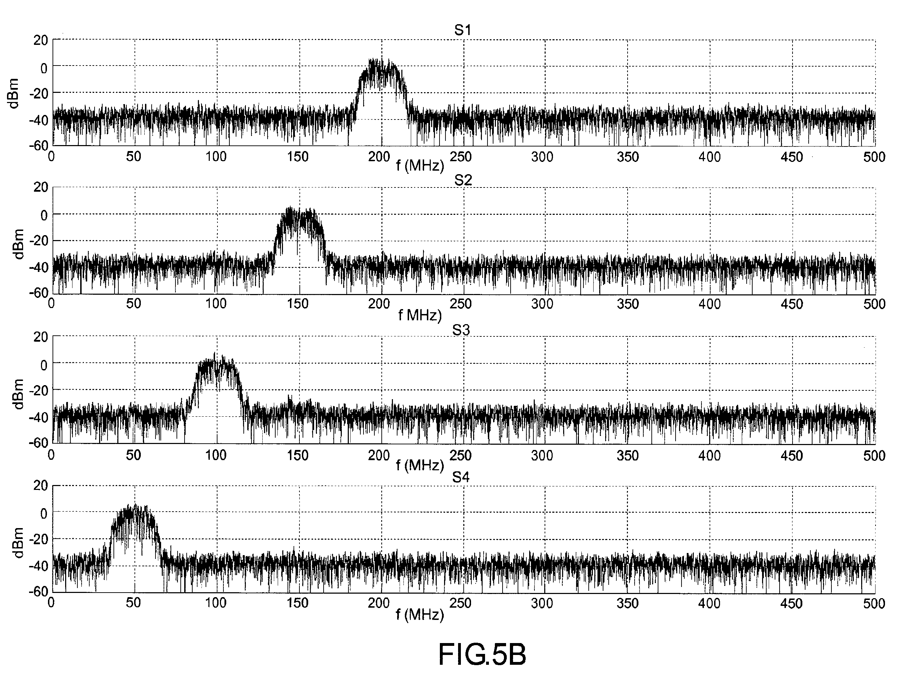

La figure 5A montre les spectres avant compensation ; on peut voir que les interférences sont importantes, et en effet l'isolation dans le pire des cas vaut -16,8 dB, ce qui est généralement insatisfaisant. Après 5 itérations (figure 5B) les interférences entre porteuses ont pratiquement disparu et l'isolation dans le pire des cas vaut -31,9 dB. En fait, déjà une seule itération permet d'amener l'isolation minimale à une valeur de -22,6 dB, qui est généralement considérée suffisante pour la plupart des applications.

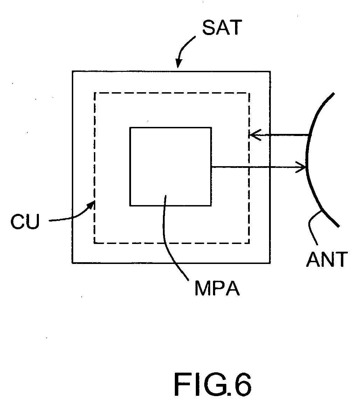

La figure 6 illustre très schématiquement l'intégration d'un amplificateur multiport MPA selon l'invention à la charge utile CU d'un satellite de télécommunications SAT. La charge utile CU est un transpondeur comportant un émetteur et un récepteur partageant une même antenne ANT ; l'amplificateur multiport constitue le stade de puissance de l'émetteur.

L'invention a été décrite en référence à un mode de réalisation particulier, mais un grand nombre de variantes est envisageable :

- l'amplificateur multiport peut être utilisé dans des applications autres que les télécommunications spatiales, et opérer dans une bande spectrale différente de celles considérées ici (bandes Ku - K - Ka), par exemple les bandes L, S, C et X ;
- les matrices d'entrée et de sortie peuvent ne pas être de Butler; en particulier si on souhaite utiliser un nombre de ports, et donc d'amplificateurs de puissance, qui n'est pas une puissance de deux ;
- le nombre d'amplificateurs peut être différent, et en particulier supérieur, au nombre de signaux à amplifier ;
- exceptionnellement, le calibrage peut s'effectuer en agissant uniquement sur la phase, ou uniquement sur le module, des poids des éléments de pondération ;
- le procédé de calibrage peut être mis en oeuvre en utilisant les signaux de trafic qui sont traités par l'amplificateur multiport lors de son fonctionnement normal ; en variante, en l'absence de trafic, on pourra utiliser de porteuses modulées par un signal de test (voire non modulées) ou simplement bruitées ;
- les signaux traités par l'amplificateur multiport peuvent ne pas présenter un plan de fréquences disjoint mais, par exemple, utiliser une même porteuse ; cependant, dans ce cas, l'isolement entre les sorties peut s'avérer moins bon que dans le cas d'un plan de fréquences disjoint ;
- le port de sortie de référence peut ne pas être celui qui présente le signal le plus puissant, bien que ce mode de réalisation soit préféré ;
- plusieurs algorithmes d'optimisation différents peuvent être utilisés pour ajuster les poids des éléments de pondération ;
- le traitement des signaux peut être déporté au moins en partie ; par exemple, les signaux acquis et numérisés par les chaînes d'acquisition peuvent être stockés dans une mémoire et transmis à une station au sol qui effectue les calculs et renvoie des signaux de commande réalisant les ajustements des éléments de pondération.

**Revendications**

1. Procédé de calibrage d'un amplificateur multiport comportant une pluralité de ports d'entrée (PE1 - PE4), une pluralité d'amplificateurs de puissance (PA1 - PA4) reliés auxdits ports d'entrées par l'intermédiaire d'une matrice de distribution de signaux (IBM) et une pluralité de ports de sortie (PS1 - PS4) reliés auxdits amplificateurs de puissance par l'intermédiaire d'une matrice de recombinaison de signaux (OBM), lesdites matrices de distribution et de recombinaison de signaux étant adaptées pour repartir un signal présent à un dit port d'entrée entre une pluralité desdits amplificateurs de puissance et pour recombiner ledit signal, amplifié, au niveau d'un dit port de sortie, un élément de pondération des signaux (EP1 - EP4) étant associé à chaque dit amplificateur de puissance ;

le procédé étant **caractérisé en ce qu'**il comporte les étapes consistant à :

a) déterminer une intercorrélation moyenne normalisée entre un signal de sortie présent à un dit port de sortie, pris comme référence, et les signaux présents aux autres dits ports de sortie ; et

b) ajuster itérativement des poids desdits éléments de pondération de façon à minimiser ladite intercorrélation moyenne normalisée ou à la rendre inférieure à un seuil prédéterminé.

2. Procédé selon la revendication 1 dans lequel ladite intercorrélation moyenne normalisée est normalisée par rapport à une auto-corrélation moyenne du signal présent audit port de sortie pris comme référence.

3. Procédé selon l'une des revendications précédentes dans lequel le port de sortie pris comme référence est celui qui présente le signal ayant le niveau de puissance le plus élevé.

4. Procédé selon l'une des revendications précédentes dans lequel lesdits poids sont des poids complexes, comportant chacun un module et une phase, ladite étape b) comprenant les sous-étapes consistant à :

b1) ajuster itérativement les phases desdits poids ; et
b2) ajuster itérativement les modules desdits poids.

5. Procédé selon la revendication 4 dans lequel lesdites sous-étapes b1) et b2) sont mises en oeuvre successivement, dans un ordre arbitraire, et dans lequel : ladite sous-étape b1) comporte l'ajustement successif des phases des poids des éléments de pondération associés aux différents amplificateurs de puissance ; et ladite sous-étape b2) comporte l'ajustement successif des modules des poids des éléments de pondération associés aux différents amplificateurs de puissance.

6. Procédé selon l'une des revendications précédentes dans lequel ladite étape b) comporte les opérations suivantes :

i. déterminer ladite intercorrélation moyenne normalisée ;
ii. appliquer un incrément prédéfini au module et/ou à la phase d'un dit poids à ajuster ;
iii. déterminer à nouveau ladite intercorrélation moyenne normalisée et, si sa valeur a augmenté, changer le signe dudit incrément ; et
iv. appliquer ledit incrément prédéfini à la phase et/ou au module dudit poids à ajuster, avec le signe déterminé lors de l'opération iii ;
v. déterminer à nouveau ladite intercorrélation moyenne normalisée et, si sa valeur a diminué tout en restant supérieure à un seuil prédéfini, répéter les opérations iv. et v.

7. Procédé selon l'une des revendications précédentes dans lequel lesdites corrélations moyennes normalisées sont déterminées à l'intérieur d'une bande de fréquence sensiblement coïncidente avec celle du signal présent sur ledit port de référence.

8. Procédé selon l'une des revendications précédentes dans lequel les signaux présents sur lesdits ports de sortie présentent un plan de fréquence disjoint.

9. Procédé selon l'une des revendications précédentes, dans lequel aucun signal de mesure n'est injecté dans ledit amplificateur afin de réaliser le calibrage.

10. Amplificateur multiport comportant une pluralité de ports d'entrée (PE1 - PE4), une pluralité d'amplificateurs de puissance (PA1 - PA4) reliés auxdits ports d'entrées par l'intermédiaire d'une matrice de distribution de signaux (IBM) et une pluralité de ports de sortie (PS1 - PS4) reliés auxdits amplificateurs de puissance par l'intermédiaire d'une matrice de recombinaison de signaux (OBM), lesdites matrices de distribution et de recombinaison de signaux étant adaptées pour repartir un signal présent à un dit port d'entrée entre une pluralité desdits amplificateurs de puissance et pour recombiner ledit signal, amplifié, au niveau d'un dit port de sortie, un élément de pondération des signaux (EP1 - EP4) étant associé à chaque dit amplificateur de puissance ;

**caractérisé en ce qu'**il comprend également un module de calibrage (MC) configuré ou programmé pour mettre en oeuvre un procédé de calibrage selon l'une des revendications précédentes.

11. Amplificateur multiport selon la revendication 10 dans lequel ledit module de calibrage comprend :

- un premier (SP1) et un deuxième (SP2) sélecteur pour sélectionner un premier et un deuxième port de sortie ;
- une première (CAS1) et une deuxième (CAS2) chaîne d'acquisition des signaux présents sur lesdits premier et deuxième ports de sortie, pour sélectionner, convertir à une fréquence intermédiaire, filtrer et numériser lesdits signaux ; et
- un processeur (DSP) programmé ou configuré pour : piloter lesdits premier et deuxième sélecteurs et lesdites première et deuxième chaînes d'acquisition ; acquérir les signaux numérisés issues desdites chaînes d'acquisition ; à partir des signaux numérisés acquis, calculer une intercorrélation moyenne normalisée entre un signal de sortie acquis depuis un port de sortie, pris comme référence, et les signaux acquis depuis les autres ports de sortie ; ajuster itérativement les poids desdits éléments de pondération pour minimiser ladite intercorrélation moyenne normalisée ou la rendre inférieure à un seuil prédéterminé.

12. Amplificateur multiport selon la revendication 11 dans lequel ledit processeur est déporté en totalité ou en partie.

13. Amplificateur multiport selon l'une des revendications 10 à 12 dans lequel chaque dit élément de pondération comprend un atténuateur (AV1 - AV4) variable et un déphaseur variable (ΦV1 - ΦV4) connectés en cascade.

14. Amplificateur multiport selon l'une des revendications 10 à 13, opérant dans au moins une bande choisie parmi la bande Ku, la bande K et la bande Ka.

15. Satellite pour télécommunications (SAT) dont la charge utile comprend un amplificateur multiport selon l'une des revendications 10 à 14.

**Patentansprüche**

1. Verfahren zum Kalibrieren eines Multiport-Verstärkers, der Folgendes umfasst: mehrere Eingangsports (PE1 - PE4), mehrere Leistungsverstärker (PA1 - PA4), die mit den Eingangsports über eine Signalverteilungsmatrix (IBM) verbunden sind, und mehrere Ausgangsports (PS1 - PS4), die mit den Leistungsverstärkern über eine Signalrekombinationsmatrix (OBM) verbunden sind, wobei die Signalverteilungs- und -rekombinationsmatrizen zum Verteilen eines an einem der Eingangsports anliegenden Signals zwischen mehreren Leistungsverstärkern und zum Rekombinieren des verstärkten Signals an einem der Ausgangsports ausgelegt sind, wobei ein Signalgewichtungselement (EP1 - EP4) mit jedem der Leistungsverstärker assoziiert ist, wobei das Verfahren **dadurch gekennzeichnet ist, dass** es die folgenden Schritte beinhaltet:

a) Ermitteln einer mittleren normalisierten Interkorrelation zwischen einem an einem der Ausgangsports, als Referenz genommen, anliegenden Ausgangssignal und den an den anderen Ausgangsports anliegenden Signalen; und
b) iteratives Justieren der Gewichtungen der Gewichtungselemente, um die mittlere normalisierte Interkomelation zu minimieren oder um sie niedriger als eine vorbestimmte Schwelle zu machen.

2. Verfahren nach Anspruch 1, wobei die mittlere normalisierte Interkorrelation relativ zu einer mittleren Autokorrelation des an dem als Referenz genommenen Ausgangsport anliegenden Signals normalisiert wird.

3. Verfahren nach einem der vorherigen Ansprüche, wobei der als Referenz genommene Ausgangsport der Port ist, der das Signal mit dem höchsten Leistungspegel hat.

4. Verfahren nach einem der vorherigen Ansprüche, wobei die Gewichtungen komplexe Gewichtungen sind, die jeweils ein Modul oder eine Phase umfassen, wobei Schritt b) die folgenden Teilschritte beinhaltet:

b1) iteratives Justieren der Phasen der Gewichtungen; und
b2) iteratives Justieren der Module der Gewichtungen.

5. Verfahren nach Anspruch 4, wobei die Teilschritte b1) und b2) nacheinander in einer willkürlichen Reihenfolge implementiert werden, und wobei: Teilschritt b1) das aufeinander folgende Justieren der Phasen der Gewichtungen der mit den verschiedenen Leistungsverstärkern assoziierten Gewichtungselemente umfasst; und Teilschritt b2) das aufeinander folgende Justieren der Module der Gewichtungen der mit den verschiedenen Leistungsverstärkern assoziierten Gewichtungselement beinhaltet.

6. Verfahren nach einem der vorherigen Ansprüche, wobei Schritt b) die folgenden Vorgänge beinhaltet:

i. Ermitteln der mittleren normalisierten Interkomelation;
ii. Anwenden eines vordefinierten Inkrements auf das Modul und/oder auf die Phase von einer der zu justierenden Gewichtungen;
iii. erneutes Ermitteln der mittleren normalisierten Interkorrelation und, wenn ihr Wert gestiegen ist, Ändern des Vorzeichens des Inkrements; und
iv. Anwenden des vordefinierten Inkrements auf die Phase und/oder das Modul der zu justierenden Gewichtung mit dem in Vorgang iii bestimmten Vorzeichen;

v. erneutes Ermitteln der mittleren normalisierten Interkorrelation und, wenn ihr Wert gesunken, aber weiterhin höher ist als eine vorbestimmte Schwelle, Wiederholen der Vorgänge iv und v.

7. Verfahren nach einem der vorherigen Ansprüche, wobei die mittleren normalisierten Interkorrelationen innerhalb eines Frequenzbands bestimmt werden, das im Wesentlichen mit dem des am Referenzport anliegenden Signals übereinstimmt.

8. Verfahren nach einem der vorherigen Ansprüche, wobei die an den Ausgangsports anliegenden Signale eine getrennte Frequenzebene haben.

9. Verfahren nach einem der vorherigen Ansprüche, wobei kein Messsignal in den Verstärker injiziert wird, um die Kalibrierung durchzuführen.

10. Multiport-Verstärker, der Folgendes umfasst: mehrere Eingangsports (PE1 - PE4), mehrere Leistungsverstärker (PA1 - PA4), die mit den Eingangsports über eine Signalverteilungsmatrix (IBM) verbunden sind, und mehrere Ausgangsports (PS1 - PS4), die mit den Leistungsverstärkern über eine Signalrekombinationsmatrix (OBM) verbunden sind, wobei die Signalverteilungs- und -rekombinationsmatrizen zum Verteilen eines an einem der Eingangsports anliegenden Signals zwischen mehreren Leistungsverstärkern und zum Rekombinieren des verstärkten Signals an einem der Ausgangsports ausgelegt ist, wobei ein Signalgewichtungselement (EP1 - EP4) mit jedem der Leistungsverstärker assoziiert ist, **dadurch gekennzeichnet, dass** er ferner ein Kalibrationsmodul (MC) umfasst, das zum Implementieren eines Kalibrationsverfahrens nach einem der vorherigen Ansprüche konfiguriert oder programmiert ist.

11. Multiport-Verstärker nach Anspruch 10, wobei das Kalibrationsmodul Folgendes umfasst:

- einen ersten (SP1) und einen zweiten (SP2) Selektor zum Auswählen eines ersten und eines zweiten Ausgangsports;
- eine erste (CAS1) und eine zweite (CAS2) Kette zum Erfassen von am ersten und zweiten Ausgangsport anliegenden Signalen, zum Auswählen, Umwandeln in eine Zwischenfrequenz, Filtern und Digitalisieren der Signale; und
- einen Prozessor (DSP), programmiert und konfiguriert zum: Steuern des ersten und zweiten Selektors und der ersten und zweiten Erfassungskette; Erfassen der von den Erfassungsketten kommenden digitalisierten Signale; Berechnen, auf der Basis der erfassten digitalisierten Signale, einer mittleren normalisierten Interkorrelation zwischen einem von einem Ausgangsport, als Referenz genommen, erfassten Ausgangssignal und den von den anderen Ausgangsports erfassten Signalen; iteratives Justieren der Gewichtungen der Gewichtungselemente, um die mittlere normalisierte Interkorrelation zu minimieren oder sie niedriger als eine vorbestimmte Schwelle zu machen.

12. Multiport-Verstärker nach Anspruch 11, wobei der Prozessor vollständig oder teilweise verlagert ist.

13. Multiport-Verstärker nach einem der Ansprüche 10 bis 12, wobei jedes der Gewichtungselemente einen variablen Dämpfer (AV1 - AV4) und einen variablen Phasenschieber ($\phi$V1 - $\phi$V4) umfasst, die in Kaskade geschaltet sind.

14. Multiport-Verstärker nach einem der Ansprüche 10 bis 13, der in wenigstens einem Band arbeitet, das aus dem Ku-Band, dem K-Band und dem Ka-Band ausgewählt ist.

15. Telekommunikationssatellit (SAT), dessen Nutzlast einen Multiport-Verstärker nach einem der Ansprüche 10 bis 14 umfasst.

**Claims**

1. A method for calibrating a multiport amplifier comprising a plurality of input ports (PE1 - PE4), a plurality of power amplifiers (PA1 - PA4) connected to said input ports by means of a signal distribution matrix (IBM) and a plurality of output ports (PS1 - PS4) connected to said power amplifiers by means of a signal recombination matrix (OBM), said signal distribution and recombination matrices being adapted to distribute a signal present on one of said input ports between a plurality of said power amplifiers and to recombine said amplified signal on one of said output ports, a signal weighting element (EP1 - EP4) being associated with each of said power amplifiers, said method being **characterised in that** it comprises the following steps:

a) determining a mean normalised intercorrelation between an output signal present on one of said output ports, taken as reference, and the signals present on said other output ports; and
b) iteratively adjusting the weights of said weighting elements so as to minimise said mean normalised intercorrelation or render it lower than a predetermined threshold.

2. The method according to claim 1, wherein said mean normalised intercorrelation is normalised relative to a mean auto-correlation of the signal present on said reference output port.

3. The method according to any one of the preceding claims, wherein said reference output port is the port that has the signal with the highest power level.

4. The method according to any one of the preceding claims, wherein said weights are complex weights, each comprising a modulus and a phase, said step b) comprising the following sub-steps:

    b1) iteratively adjusting the phases of said weights; and
    b2) iteratively adjusting the moduli of said weights.

5. The method according to claim 4, wherein said sub-steps b1) and b2) are implemented successively, in a random order, and wherein: said sub-step b1) comprises successively adjusting phases of the weights of the weighting elements associated with the various power amplifiers, and said sub-step b2) comprises successively adjusting the moduli of the weights of the weighting elements associated with the various power amplifiers.

6. The method according to any one of the preceding claims, wherein said step b) comprises the following operations:

    i. determining said mean normalised intercorrelation;
    ii. applying a predefined increment to the modulus and/or to the phase of one of said weights to be adjusted;
    iii. re-determining said mean normalised intercorrelation and, if its value has increased, changing the sign of said increment; and
    iv. applying said predefined increment to the phase and/or to the modulus of said weight to be adjusted, with the sign determined during operation iii;
    v. re-determining said mean normalised intercorrelation and, if its value has decreased whilst remaining higher than a predetermined threshold, repeating operations iv and v.

7. The method according to any one of the preceding claims, wherein said mean normalised intercorrelations are determined within a frequency band that substantially coincides with that of the signal present on said reference port.

8. The method according to any one of the preceding claims, wherein the signals present on said output ports have a distinct frequency plane.

9. The method according to any one of the preceding claims, wherein no measurement signal is injected into said amplifier in order to carry out the calibration.

10. A multiport amplifier comprising a plurality of input ports (PE1 - PE4), a plurality of power amplifiers (PA1 - PA4) connected to said input ports by means of a signal distribution matrix (IBM) and a plurality of output ports (PS1 - PS4) connected to said power amplifiers by means of a signal recombination matrix (OBM), said signal distribution and recombination matrices being adapted to distribute a signal present on one of said input ports between a plurality of said power amplifiers and to recombine said amplified signal on one of said output ports, a signal weighting element (EP1 - EP4) being associated with each of said power amplifiers,
**characterised in that** it further comprises a calibration module (MC) configured or programmed to implement a calibration method according to any one of the preceding claims.

11. The multiport amplifier according to claim 10, wherein said calibration module comprises:

    - a first (SP1) and a second (SP2) selector for selecting a first and a second output port;
    - a first (CAS1) and a second (CAS2) chain for acquiting signals present on said first and second output ports, for selecting, converting to an intermediate frequency, filtering and digitising said signals; and
    - a processor (DSP) programmed or configured to: control said first and second selectors and said first and second acquisition chains, acquire the digitised signals coming from said acquisition chains, compute, on the basis of the acquired digitised signals, a mean normalised intercorrelation between an output signal acquired from an output port, taken as reference, and the signals acquired from the other output ports, iteratively adjust the weights of said weighting elements so as to minimise said mean normalised intercorrelation or render it lower than a predetermined threshold.

12. The multiport amplifier according to claim 11, wherein said processor is completely or partly remote.

13. The multiport amplifier according to any one of claims 10 to 12, wherein each of said weighting elements comprises a variable attenuator (AV1 - AV4) and a variable phase shifter ($\phi$V1 - $\phi$V4) connected in a cascade like manner.

14. The multiport amplifier according to any one of claims 10 to 13, operating in at least one band selected from the Ku band, the K band and the Ka band.

**15.** A telecommunications satellite (SAT), the payload of which comprises a multiport amplifier according to any one of claims 10 to 14.

FIG.1

FIG.2A

FIG.2B

FIG.2C

FIG.3

FIG.4

FIG.5A

FIG.5B

FIG.6

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2008135753 A

- US 20120319772 A

**Littérature non-brevet citée dans la description**

- **MARIO CARON ; XINPING HUANG.** Estimation and compensation of amplifier gain and phase mismatches in a multiple port amplifier subsystem. *ESA Workshop on Advanced Flexible Telecom Payloads,* 18 Novembre 2008